(19) **Europäisches Patentamt / European Patent Office / Office européen des brevets**

(11) **EP 1 612 949 B1**

(12) **EUROPEAN PATENT SPECIFICATION**

(45) Date of publication and mention
of the grant of the patent:
**21.04.2010 Bulletin 2010/16**

(51) Int Cl.:
**H03M 13/15** (2006.01) **G06F 11/10** (2006.01)

(21) Application number: **04425485.2**

(22) Date of filing: **30.06.2004**

(54) **Method and system for correcting errors in electronic memory devices**

Verfahren und Vorrichtung für die Fehlerkorrektur in elektronischen Speichern

Procédé et dispositif de correction d'erreurs pour mémoires électroniques

(84) Designated Contracting States:
**DE FR GB IT**

(43) Date of publication of application:
**04.01.2006 Bulletin 2006/01**

(73) Proprietor: **STMicroelectronics Srl**
**20041 Agrate Brianza (MB) (IT)**

(72) Inventors:
• **Marelli, Alessia**
**24044 Dalmine (Bergamo) (IT)**
• **Ravasio, Roberto**
**24036 Ponte San Pietro (Bergamo) (IT)**
• **Micheloni, Rino**
**22078 Turate (Como) (IT)**

(74) Representative: **Niederkofler, Oswald et al**
**Samson & Partner**
**Patentanwälte**
**Widenmayerstrasse 5**
**80538 München (DE)**

(56) References cited:
**US-A- 5 440 570      US-A- 5 459 742**

• **GRAVANO S: "DECODING THE TRIPLE-ERROR-CORRECTING (15,5) BINARY BCH CODE BY THE ANALYTIC SOLUTION OF THE CUBIC ERROR-LOCATOR POLYNOMIAL OVER GF(24)" INTERNATIONAL JOURNAL OF ELECTRONICS, TAYLOR AND FRANCIS.LTD. LONDON, GB, vol. 68, no. 2, 1 February 1990 (1990-02-01), pages 175-180, XP000099750 ISSN: 0020-7217**
• **KATSAROS A: "DECODING OF THE (15, 7) AND (31, 21) BINARY BCH CODES" INTERNATIONAL JOURNAL OF ELECTRONICS, TAYLOR AND FRANCIS.LTD. LONDON, GB, vol. 64, no. 4, April 1988 (1988-04), pages 637-640, XP000859074 ISSN: 0020-7217**
• **YAMAGISHI A ET AL: "A CONSTRUCTION METHOD FOR DECODERS OF BCH CODES USING ROM'S" SYSTEMS, COMPUTERS, CONTROLS, SCRIPTA PUBLISHING COMPANY. WASHINGTON, US, vol. 11, no. 6, November 1980 (1980-11), pages 58-67, XP000648455**
• **LU E-H ET AL: "Fast decoder for triple-error-correcting primitive binary BCH codes with odd m" IEE PROCEEDINGS : COMMUNICATIONS, INSTITUTION OF ELECTRICAL ENGINEERS, GB, vol. 145, no. 2, 16 April 1998 (1998-04-16), pages 60-64, XP006010891 ISSN: 1350-2425**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

Field of application

The present invention relates to a method and system for correcting errors in electronic memory devices, for example read and write non volatile memories, particularly Flash electronic memories.

The invention particularly relates to read and write memories having a NAND structure and the following description is made with reference to this specific field of application for convenience of illustration only, since the invention can be also applied to memories with NOR structure, provided that they are equipped with an error correction system.

Even more particularly, the invention relates to a method and system for correcting errors in electronic read and write non volatile memory devices, particularly Flash memories, of the type providing the use of a BCH binary correction code.

Prior art

As it is well known in this specific technical field, two-level and multilevel NAND memories have such a Bit Error Rate (BER) as to require an Error Correction system (ECC) in order to allow them to be used as much reliably as possible.

Among the innumerable present correction systems ECC a particular importance is assumed by the so-called cyclical correction codes, particularly BCH binary codes.

Known decoding method using BCH codes are described for instance in the following articles:

    Gravano S: "Decoding the triple-error-correcting (15, 5) binary BCH code by the analytic solution of the cubic error-locator polynomial over GF(24)", International Journal of Electronics, vol. 68, no. 2, 1 February 1990, pages 175-180,

    Katsaros A: "Decoding of the (15, 7) and (31, 21) binary BCH codes", International Journal of Electronics, vol. 64, no. 4, April 1988, pages 637-640; and

    Yamagishi A. et al.: "A construction method for decoders of BCH codes using ROM's", Systems, Computer, Controls, Scripta publishing company, Washington, US, vol. 11, no. 6, November 1980, pages 58-67.

Also known from the US Patent No. 5,459,742 to Cassidy et al. (Quantum Corporation) is a computer system including a main memory able to use DRAM devices having relatively high level of bad cells. In particular, the system comprises an EDC circuit to perform a BCH code.

The main features of this BCH code are quoted hereafter by way of comparison.

This code operates on a block of binary symbols. If N (4096 + 128) is the block size, the number of parity bits is P (52bit).

The canonical coding and decoding structures process the data block by means of sequential operations on the bits to be coded or decoded.

The arithmetic operators (sum, multiplication, inversion) in GF(2) are extremely simple (XOR, AND, NOT).

The code corrects K bits.

For a better understanding of all the aspects of the present invention, the structure of the error correction systems using a BCH code will be analysed hereafter.

The BCH structure

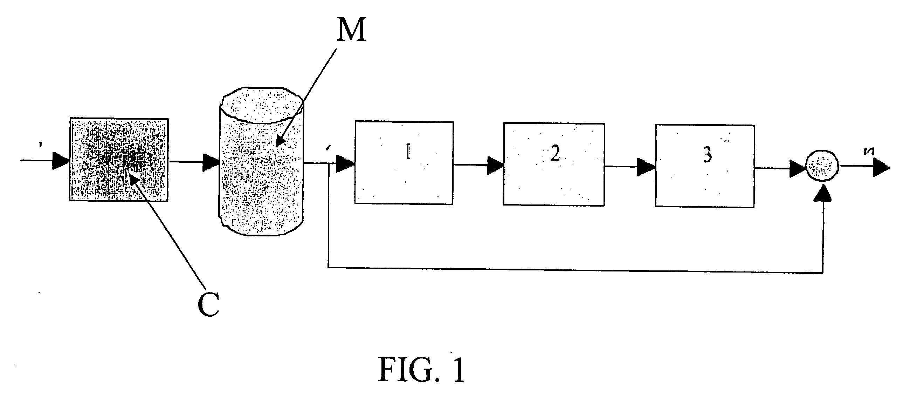

The typical structure of a BCH code is shown in the attached figure 1 wherein the block indicated with C represents the coding step while the other blocks 1, 2 and 3 are active during the decoding and they refer to the syndrome calculation, to the error detection polynomial calculation (for example by means of the Berlekamp algorithm) and to the error detection, respectively. The block M indicates a storage and/or transfer medium of the coded data.

It is worth realising blocks C, 1 and 3 by means of known sequential structures, (for example as described by: Shu Lin, Daniel Costello - in: "Error Control Coding: Fundamentals and Applications") having a latency being proportional to the length of the message to be stored.

In particular for a traditional sequential implementation:

    BLOCK C: the block latency is equal to the message to be stored (4096 bits);

    BLOCK 1: the block latency is equal to the coded message (for a four-error-corrector code 4096+52);

    BLOCK 3: the block latency is equal to the coded message (for a four-error-corrector code 4096+52).

By means of traditional implementations of the coding block C and syndrome calculation block 1, the latency time used for these operations can be partially or totally overlapped respectively to the information writing time in the memory and to the data reading time (without any correction) by the user. These coding and decoding steps can thus not require an increase in the time required for reading and writing. At the end of the information block reading (N bits), the block 1 has calculated the syndromes. If all the syndromes are equal to 0, it is not necessary to perform other operations. If the syndromes are not equal to 0, the decoding steps 2 and 3 are to be performed. The impact on the system performances given by the performance of these two steps (2 and 3), however they are implemented, is much higher the more the packages with one or more errors are frequent.

Although advantageous under several aspects, known systems do not allow the frequency of use of decoding blocks 2 and 3 to be reduced yet, which would allow to reduce the decoding complexity.

The technical problem underlying the present invention is to provide an error correction method and system allowing the decoding step burden to be reduced, overcoming the drawbacks of the solutions provided by the prior art.

## Summary of the invention

The solution idea underlying the invention is to decrease the frequency of use of decoding blocks 2 and 3 by using the binary properties of BCH correction codes, particularly a relation on the syndromes.

It is thus possible to optimise the system speed by recognising when a single error occurred and by using for this case a Hamming decoding.

On the basis of this solution idea, the technical problem is solved by a system as previously indicated and defined in claim 4.

The problem is also solved by a method as previously indicated and defined in claim 1.

The features and advantages of the system and method according to the invention will be apparent from the following description of an embodiment thereof given by way of non limiting example with reference to the attached drawings.

In these drawings:

## Brief description of the drawings

- Figure 1 is a schematic block view of a BCH coding and decoding system;

- Figure 2 is a schematic block view of a BCH coding and decoding system emphasising the blocks being concerned only in case of error;

- Figure 3 shows in a diagram a comparison between the error probabilities in two-level memories and in multilevel memories;

- Figure 4 is a schematic block view of a coding and decoding system according to the present invention;

- Figure 5 shows in a diagram a comparison between the error probabilities in two-level memories and in multilevel memories according to the method of the present invention by indicating the frequency of use of the heaviest decoding blocks.

## Detailed description

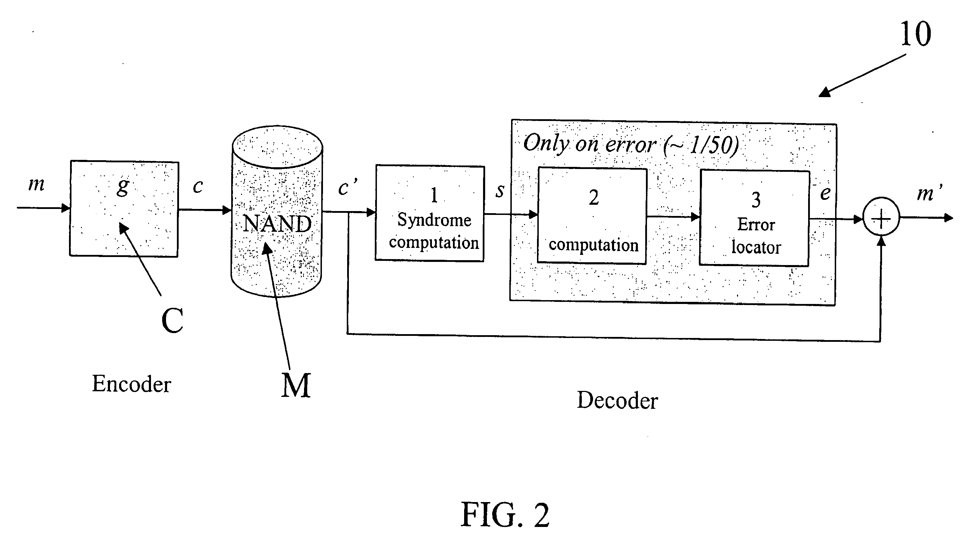

With reference to the drawings of the attached figures, and particularly to the example of figure 2, an error correction system for electronic non volatile memory devices, particularly multilevel reading and writing memories, is globally and schematically indicated with 10.

The system 10 comprises a block indicated with C representing the coding step; a block M indicating the electronic memory device and a group of blocks 1, 2 and 3 which are active during the decoding step. In particular, the block 1 is responsible for calculating the so-called code syndrome, the block 2 is a calculation block of the error detector polynomial, while the block 3 is responsible for detecting the error by means of the Chien wrong position search algorithm.

The BCH decoding requires the syndrome calculation, block 1. This calculation can occur while the user reads data from the memory and therefore it can not involve a time over-head.

If all the calculated syndromes are equal to zero, the data package being read is correct or the number of errors is higher than 2K, where K indicates the code corrective capacity. If not all the syndromes are null, it is necessary to proceed with the decoding steps 2 and 3. These steps, however implemented, involve a time over-head for the implementation thereof.

The impact of this over-head on the system performances is much higher the highest the frequency at which errors occur is.

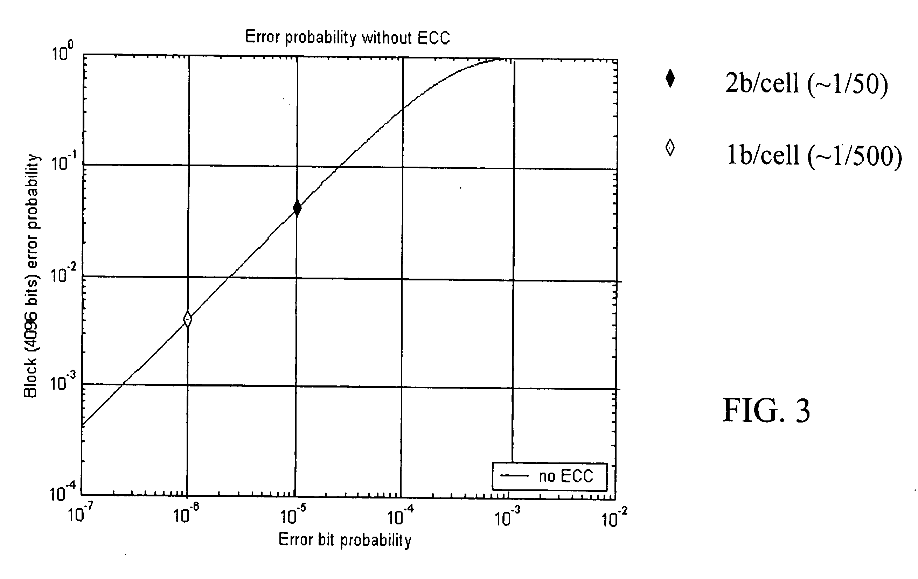

Figure 3 emphasises, by way of example, the error probabilities of a block of 4096 bits for EEPROM Flash memories comprising 1bit/cell and 2bits/cell according to the single bit error probability. The frequency at which blocks 2 and 3 must intervene in the case of multilevel memories is 1 out of 50.

The invention is particularly suitable for the use in Flash EEPROM memories having a NAND structure; nevertheless nothing prevents the invention from being also applied to memories with NOR structure or memories of different type, provided that they are equipped with an error correction system.

Advantageously, the system according to the invention is based on a combination between a BCH code and a Hamming code in order to obtain a decoding step with a reduced use of decoding blocks 2 and 3.

The mathematical basics whereon the BCH and Hamming combination of the invention is based will be described hereafter.

The final system structure will be shown afterwards.

Hamming codes are particular BCH codes being capable of correcting a single error.

Both codes operate on a binary alphabet for which $S_{2i} = S_i^2$.

In order to reduce the decoding over-head due to the implementation of steps 2 and 3, a relation between the wrong message syndromes has been searched for in order to recognise when a single error occurred and apply in this case a Hamming decoding.

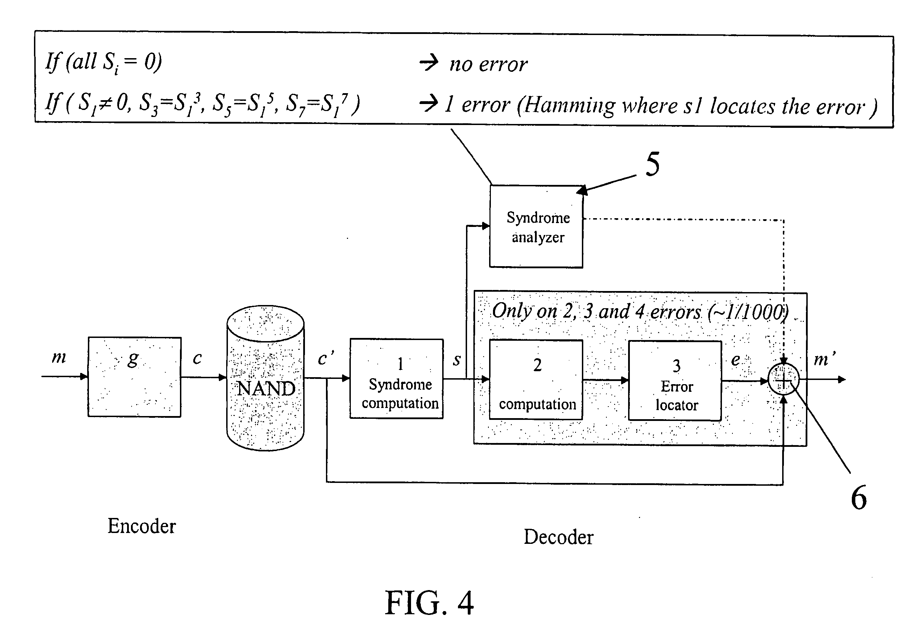

In substance, the invention being shown in figure 4 provides a preventive control step of the need to correct a single error and a subsequent intervention demand of the system portion implementing the Hamming decoding, block 5 in figure 4.

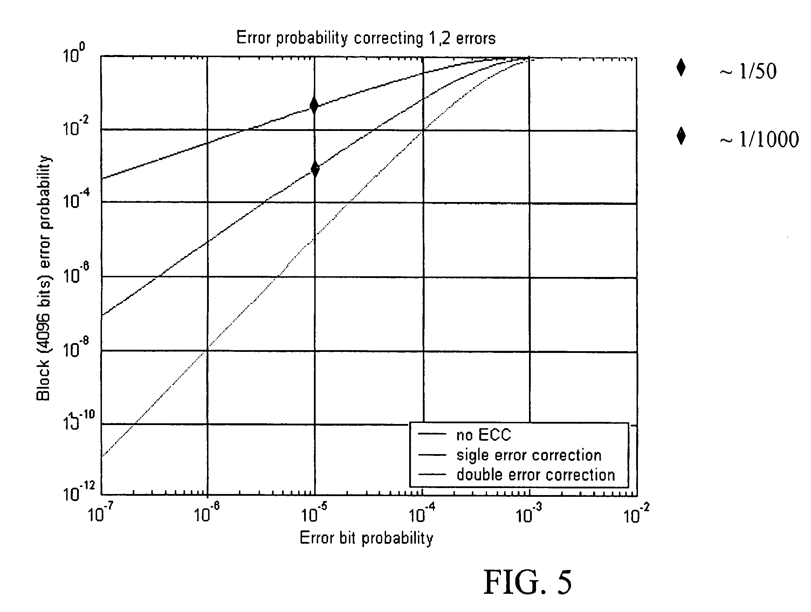

Therefore the correction frequency using blocks 2 and 3 of the structure 10 drastically decreases. As exemplified in figure 5 in the case of 2bits/cell Flash memories, an intervention frequency of blocks 2 and 3 being equal to 1 out of 50 turns into an intervention frequency of blocks 2 and 3 being equal to 1 out of 1000.

Advantageously, the preventive control step is entrusted to the so-called decoding method "syndromes", i.e. to the block 1.

The syndromes immediately provide the information if an error occurred or not.

A matrix relation is now drawn, allowing to recognise from the syndromes calculated from the block 1 if a single error occurred:

$$\begin{bmatrix} S_1 & S_2 & S_3 & \cdots & S_v \\ S_2 & S_3 & S_4 & \cdots & S_{v+1} \\ S_3 & S_4 & \cdots & \cdots & S_{v+2} \\ \vdots & \vdots & \vdots & & \vdots \\ S_v & S_{v+1} & S_{v+2} & \cdots & S_{2v-1} \end{bmatrix}$$

In this case all the matrix determinants must be cancelled by setting $v = t$, $v = t-1,..., v = 2$ (t indicates the code correction capacity). Only $S_1$ must be different from zero.

The following relations are thus obtained, also by exploiting the binary property $S_{2i} = S_i^2$:

$$\begin{cases} S_1 \neq 0 \\ S_3 = S_1^3 \\ \dots \\ S_{2t-1} = S_1^{2t-1} \end{cases}$$

It is worth remembering that in the case of a single error a Hamming code is used. This means that the syndrome S 1 univocally identifies the wrong position.

In fact the primitive element power corresponding to the obtained syndrome S1, represents the wrong position. If for example the obtained syndrome is the binary expression of the element $\alpha^{12}$ then the twelfth position is the wrong one.

The block 5 of figure 4 comprises means for identifying the relations between the above-mentioned syndromes and, if they are met, for obtaining from the syndrome S1 the error position. These means known in literature can be specific for correcting a single error in order to rapidly play the role thereof.

A particular exemplifying case is represented by a combinatory logic identifying the relations between the syndromes and a ROM memory translating the syndromes into the corresponding error positions.

The situation can be summed up by saying that all the possible syndromes have an associated error configuration and according to the present invention a BCH correction (block 2 and 3) is used only when two or more errors occurred.

The general system structure according to the invention is shown in figure 4 and it clearly shows the presence of an analysis block 5 connected to the output of the block 1 responsible for the syndrome calculation step.

The output of the block 5 is directly transferred into an adder node 6 wherein also the output of the error detection block 3 converges.

Therefore when the system 10 detects the presence of a single error, the control is entrusted to a Hamming code decoding correcting only that error.

The frequency of use of blocks 2 and 3 is considerably reduced.

Consequently the speed increases since blocks 2 and 3, being structurally more complex, are used rarely with respect to known solutions.

This advantage is well shown in the diagram of figure 5 wherefrom it can be recognised how the error probability is different for single errors and for multiple errors, making the use of the method and system according to the present invention very profitable.

The method according to the invention thus provides the alternative use of a Hamming correction code at each detection of a single error to be corrected.

The detection of a single error is obtained by analysing the result of the code syndrome calculation step at the output of block 1.

Upon detecting a single error, blocks 2 and 3 are bypassed and the decoding is performed only by means of the Hamming code.

**Claims**

1. A method for correcting errors of encoded data in an electronic memory device, comprising:

   determining by analysing the result of a syndrome calculation step if a single error or multiple errors has occurred
   if multiple errors have occurred, detecting the multiple errors using a BCH binary error decoding correction comprising calculating an error locator polynominal and detecting an error;
if a single error has occurred, bypassing the BCH binary error decoding correction and detecting the single error using a Hamming code decoding correction; and
correcting the encoded data by converging the detected respective single error or multiple errors and the encoded data
in an adder node.

2. The method according to claim 1, **characterised in that** the recognition by the syndromes of the presence of a single error is based on the following matrix:

$$\begin{bmatrix} S_1 & S_2 & S_3 & \cdots & S_v \\ S_2 & S_3 & S_4 & \cdots & S_{v+1} \\ S_3 & S_4 & \cdots & \cdots & S_{v+2} \\ \vdots & \vdots & \vdots & & \vdots \\ S_v & S_{v+1} & S_{v+2} & \cdots & S_{2v-1} \end{bmatrix}$$

putting equal to zero all the matrix determinants which are obtained by setting $v = t$, $v = t-1$,..., $v = 2$, wherein t indicates a code correction capacity and only with $S_1$ and the powers of $S_1$ different from zero, being $S_{2i} = S_i^2$.

3. The method according to claim 2, further comprising using the binary property $S_{2i} = S_i^2$ in the matrix to obtain the following relation:

$$\begin{cases} S_1 \neq 0 \\ S_3 = S_1^3 \\ \dots \\ S_{2t-1} = S_1^{2t-1} \end{cases}$$

4. A system for correcting errors in an electronic memory device, comprising:

a coding block (C) with a BCH binary correction code, and
a cascade of decoding blocks (1, 2, 3) comprising a first block (1) for calculating a code syndrome, a second block (2) for calculating an error locator polynomial and a third block (3) for detecting an error,
**characterised by**:

an analysis and detection block (5) connected to the output of said first block (1) for detecting a single error by analysing the code syndrome and for correcting the single error using a Hamming code decoding correction, and
an adder node (6) having a first input connected to an output of said analysis and detection block (5), a second input connected to an output of said third block (3) and a third input connected to an input of said first block (1), for reducing a decoding time in case of a single error.

5. The system according to claim 4, **characterised in that** said electronic memory device is a multilevel memory.

**Patentansprüche**

1. Verfahren zum Korrigieren von Fehlern codierter Daten in einer elektronischen Speichervorrichtung, welches umfasst:

Bestimmen, durch Analysieren des Ergebnisses eines Syndromberechnungsschrittes, ob ein einfacher Fehler oder mehrfache Fehler stattgefunden haben,
falls mehrfache Fehler stattgefunden haben, Detektieren der mehrfachen Fehler unter Verwendung einer BCH-Binärfehler-Decodierungskorrektur, die ein Berechnen eines Fehlerlokalisierungspolynoms und Detektieren eines Fehlers umfasst;
falls ein einfacher Fehler stattgefunden hat, Umgehen der BCH-Binärfehler-Decodierungskorrektur und Detektieren des einfachen Fehlers unter Verwendung einer Hammingcode-Decodierungskorrektur; und
Korrigieren der codierten Daten durch Zusammenführen des detektierten einfachen Fehlers bzw. der mehrfachen Fehler und der codierten Daten in einem Addiererknoten.

2. Verfahren gemäß Anspruch 1, **dadurch gekennzeichnet, dass** die syndrombasierte Erkennung des Vorliegens eines einfachen Fehlers auf der folgenden Matrix beruht:

$$
\begin{bmatrix}
S_1 & S_2 & S_3 & \cdots & S_v \\
S_2 & S_3 & S_4 & \cdots & S_{v+1} \\
S_3 & S_4 & \cdots & \cdots & S_{v+2} \\
\cdot & \cdot & \cdot & & \cdot \\
\cdot & \cdot & \cdot & & \cdot \\
\cdot & \cdot & \cdot & & \cdot \\
S_v & S_{v+1} & S_{v+2} & \cdots & S_{2v-1}
\end{bmatrix}
$$

**3.** Verfahren gemäß Anspruch 2, welches ferner ein Benutzen der binären Eigenschaft $S_{2i} = S_i^2$ in der Matrix umfasst, um die folgende Relation zu erhalten:

$$
\begin{cases}
S_1 \neq 0 \\
S_3 = S_1^3 \\
\cdots \\
S_{2t-1} = S_1^{2t-1}
\end{cases}
$$

**4.** System zum Korrigieren von Fehlern in einer elektronischen Speichervorrichtung, welches umfasst:

einen Codierblock (C) mit einem BCH-Binärkorrekturcode, und
einer Kaskade von Decodierungsblöcken (1, 2, 3), die einen ersten Block (1) zum Berechnen eines Codesyndroms, einen zweiten Block (2) zum Berechnen eines Fehlerlokalisierungspolynoms und einen dritten Block (3) zum Detektieren eines Fehlers umfassen,
**gekennzeichnet durch**:

einen Analyse- und Detektierungsblock (5), der mit dem Ausgang des ersten Blocks (1) verbunden ist, zum Detektieren eines einfachen Fehlers **durch** Analysieren des Codesyndroms und zum Korrigieren des einfachen Fehlers unter Verwendung einer Hammingcode- Decodierungskorrektur, und
einen Addiererknoten (6), der einen ersten Eingang aufweist, der mit einem Ausgang des Analyse- und Detektierungsblocks (5) verbunden ist, einen zweiten Eingang, der mit einem Ausgang des dritten Blocks (3) verbunden ist, und einen dritten Eingang, der mit einem Eingang des ersten Blocks (1) verbunden ist, um eine Decodierungszeit im Falle eines einfachen Fehlers zu reduzieren.

**5.** System gemäß Anspruch 4, **dadurch gekennzeichnet, dass** die elektronische Speichervorrichtung ein Mehrpegelspeicher ist.

## Revendications

**1.** Méthode pour corriger des erreurs de données codées dans un dispositif de mémoire électronique, comprenant :

♦ déterminer en analysant le résultat d'une étape de calcul de syndrome si une seule erreur ou de multiples erreurs se sont produites ;

♦ si de multiples erreurs se sont produites, détecter les multiples erreurs en utilisant une correction de décodage d'erreur binaire BCH comprenant le calcul d'un polynôme localisateur d'erreur et la détection d'une erreur ;

♦ si une seule erreur s'est produite, contourner la correction de décodage d'erreur binaire BCH et détecter la seule erreur en utilisant une correction de décodage de code de Hamming ; et

♦ corriger les données codées en convergeant la seule erreur ou les multiples erreurs respective(s) détectée(s) et les données codées dans un noeud additionneur.

**2.** Méthode selon la revendication 1, **caractérisée en ce que** la reconnaissance par les syndromes de la présence d'une seule erreur est basée sur la matrice suivante :

$$
\begin{bmatrix}
S_1 & S_2 & S_3 & \cdots & S_v \\
S_2 & S_3 & S_4 & \cdots & S_{v+1} \\
S_3 & S_4 & \cdots & \cdots & S_{v+2} \\
\vdots & \vdots & \vdots & & \vdots \\
S_v & S_{v+1} & S_{v+2} & \cdots & S_{2v-1}
\end{bmatrix}
$$

en mettant égal à zéro tous les déterminants de matrice qui sont obtenus en établissant v = t, v = t-1, ..., v = 2, où t indique une capacité de correction de code et uniquement avec $S_1$ et les puissances de $S_1$ différentes de zéro, étant $S_{2i} = S_i^2$.

**3.** Méthode selon la revendication 2, comprenant en outre la propriété binaire $S_{2i} = S_i^2$ dans la matrice afin d'obtenir la relation suivante :

$$\begin{cases} S_1 \neq 0 \\ S_3 = S_1^3 \\ \dots \\ S_{2t-1} = S_1^{2t-1} \end{cases}$$

**4.** Système pour corriger des erreurs dans un dispositif de mémoire électronique, comprenant :

◆ un bloc de codage (C) avec un code de correction binaire BCH, et
◆ une cascade de bloc's de décodage (1, 2, 3) comprenant un premier bloc (1) pour calculer un syndrome de code, un deuxième bloc (2) pour calculer un polynôme localisateur d'erreur et un troisième bloc (3) pour détecter une erreur,

**caractérisé par** :

◆ un bloc d'analyse et de détection (5) connecté à la sortie dudit premier bloc (1) pour détecter une seule erreur en analysant le syndrome de code et pour corriger la seule erreur en utilisant une correction de décodage de code de Hamming, et

◆ un noeud additionneur (6) ayant une première entrée connectée à une sortie dudit bloc d'analyse et de détection (5), une deuxième entrée connectée à une sortie dudit troisième bloc (3) et une troisième entrée connectée à une entrée dudit premier bloc (1), pour réduire un temps de décodage dans le cas d'une seule erreur.

**5.** Système selon la revendication 4, **caractérisé en ce que** ledit dispositif de mémoire électronique est une mémoire multiniveau.

FIG. 1

FIG. 2

FIG. 3

EP 1 612 949 B1

FIG. 4

FIG. 5

EP 1 612 949 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5459742 A, Cassidy

**Non-patent literature cited in the description**

- **Gravano S.** Decoding the triple-error-correcting (15, 5) binary BCH code by the analytic solution of the cubic error-locator polynomial over GF(24). *International Journal of Electronics,* 01 February 1990, vol. 68 (2), 175-180

- **Katsaros A.** Decoding of the (15, 7) and (31, 21) binary BCH codes. *International Journal of Electronics,* April 1988, vol. 64 (4), 637-640
- **Yamagishi A. et al.** A construction method for decoders of BCH codes using ROM's. *Systems, Computer, Controls, Scripta publishing company,* November 1980, vol. 11 (6), 58-67